Europäisches Patentamt
European Patent Office
Office européen des brevets

(19)

(11) Veröffentlichungsnummer: **0 365 987 A2**

(12)

# EUROPÄISCHE PATENTANMELDUNG

(21) Anmeldenummer: **89119313.8**

(51) Int. Cl.[5]: **G03F 7/32**

(22) Anmeldetag: **18.10.89**

(30) Priorität: **26.10.88 DE 3836402**

(43) Veröffentlichungstag der Anmeldung: **02.05.90 Patentblatt 90/18**

(84) Benannte Vertragsstaaten: **DE FR GB IT**

(71) Anmelder: **HOECHST AKTIENGESELLSCHAFT**
**Postfach 80 03 20**
**D-6230 Frankfurt am Main 80(DE)**

(72) Erfinder: **Schlosser, Hans-Joachim, Dipl.-Chem.**
**Am Rosengarten 2a**
**D-6200 Wiesbaden(DE)**
Erfinder: **Schön, Günther**
**Friedrichstrasse 39**
**D-6200 Wiesbaden(DE)**

(54) **Entwicklungslösemittel für durch Photopolymerisation vernetzbare Schichten sowie Verfahren zur Herstellung von Reliefformen.**

(57) Es wird ein Entwicklungslösemittel für durch Photopolymerisation vernetzbare Schichten beschrieben, enthaltend ein Bindemittel auf der Basis eines elastomeren Polymeren, ein hiermit verträgliches photopolymerisierbares Monomeres, sowie einen Photoinitiator. Das Entwicklungslösemittel enthält als wesentliche Komponente einen Ester der allgemeinen Formel I

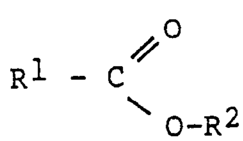

(I)

worin

$R^1$ und $R^2$ gleich oder verschieden sein können und $(C_1$-$C_{13})$n- oder iso-Alkyl, $C_5$-, $C_6$- oder $C_{12}$-Cycloalkyl, $(C_1$-$C_3)$Alk-$C_6$-aryl, $C_6$ oder $C_{10}$-Aryl bedeuten, mit der Maßgabe, daß die Summe der Kohlenstoffatome in $R^1$ und $R^2$ 6 bis 13 beträgt.

Das Entwicklungslösemittel ist im Vergleich zu Lösemitteln des Standes der Technik ungiftig, schnell aus der Schicht zu entfernen und weist eine hohe Kapazität für Schichtbestandteile auf.

EP 0 365 987 A2

# Entwicklungslösemittel für durch Photopolymerisation vernetzbare Schichten sowie Verfahren zur Herstellung von Reliefformen.

Die Erfindung betrifft ein Entwicklungslösemittel für durch Photopolymerisation vernetzbare Schichten, enthaltend ein Bindemittel auf der Basis eines elastomeren Polymeren, ein hiermit verträgliches photopolymerisierbares Monomeres sowie einen Photoinitiator.

Die Herstellung von Reliefformen, insbesondere von Flexodruckplatten, durch bildmäßiges Belichten und anschließendes Entwickeln und Auswaschen von durch Photopolymerisation vernetzbaren Schichten ist seit langem bekannt.

Zur Herstellung solcher Formen wird die Photopolymerschicht bildmäßig mit aktinischem Licht belichtet; die Ausbildung des Reliefs wird anschließend durch Auswaschen der nicht belichteten und damit nicht vernetzten Anteile der Schicht mit dem Entwicklungslösemittel ermöglicht. Aufgabe des Entwicklungslösemittels ist es, die nicht vernetzten Anteile der Schicht möglichst schnell zu lösen, wobei das Lösemittel andererseits aber von den vernetzten Anteilen der Platte möglichst leicht zu entfernen sein muß, damit die Platte schnell trocken ist.

Eingesetzt werden daher heute zumeist Entwicklungslösemittel mit niedrigem Siedepunkt.

In der DE-A 22 15 090 werden z. B. Methylethylketon, Benzol, Toluol, Xylol, Tetrachlorkohlenstoff, Trichlorethan, Trichlorethylen, Methylchloroform und Tetrachlorethan sowie deren Gemische als geeignete Lösemittel beschrieben.

Nachteilig bei den genannten chlorierten Kohlenwasserstoffen sind Toxizität und Entsorgungsprobleme. Werden chlorierte Kohlenwasserstoffe als Entwicklungslösemittel verwendet, quellen die zu entfernenden Bereiche schon auf der Platte sehr stark, und die steigende Konzentration der im Entwicklungslösemittel gelösten Bestandteile der nicht vernetzten Anteile der Schicht führt zu einer starken Viskositätszunahme des Lösemittels. Dies hat zur Folge, daß die Kapazität des Entwicklungslösemittels sehr beschränkt ist und schon bei einer 5%igen Beladung das Lösemittel unbrauchbar wird. Eine weitere Folge der starken Viskositätszunahme ist, daß die Platten auch schon bei einer Beladung von weniger als 5 % sehr langsam zu entwickeln sind.

Von den in der DE-A 22 15 090 genannten nicht chlorierten Kohlenwasserstoffen sind Benzol, Toluol und Xylol zu nennen. Diese Lösemittel weisen als nachteilig auf, daß sie leicht brennbar sind und außerdem zu einer starken Quellung der Schicht und folglich nur zu einer langsamen Entwicklung und Trocknung der Platte führen.

Wegen ihres niedrigen Flammpunktes ist zudem ihr Einsatz in nicht explosionsgeschützten Entwicklungsgeräten nicht möglich.

In der DE-A 36 00 116 werden höhersiedende Entwicklungslösemittel beschrieben, die als wesentliche Bestandteile verzweigte, einfach oder dreifach olefinisch ungesättigte cyclische oder gesättigte oder einfach bis dreifach olefinisch ungesättigte cyclische aliphatische Kohlenwasserstoffe, Alkohole oder Ketone enthalten. Insbesondere werden Monoterpene genannt. Das im Beispiel verwendete Limonen besitzt zwar gute Entwicklungseigenschaften, ist aber sauerstoffempfindlich und hautreizend, Eigenschaften, die ein Entwicklungslösemittel nicht aufweisen sollte. Ein weiterer Nachteil ist, daß Limonen nur eine sehr langsame Entwicklung erlaubt und schwer aus der Schicht zu entfernen ist.

Aufgabe war es daher, ein Entwicklungslösemittel für Photopolymerschichten bereitzustellen, das

- nicht toxisch ist,
- einen hohen Flammpunkt besitzt,
- möglichst vollständig und schnell aus der Schicht entfernbar ist, ohne die Schicht zu quellen,
- sowie eine möglichst geringe Viskositätszunahme bei Aufnahme von Bestandteilen der Schicht aufweist, die es ermöglicht, trotz geforderter hoher Kapazität, schnell und einwandfrei entwickeln zu können.

Die Lösung der Aufgabe wird durch ein Entwicklungslösemittel der eingangs beschriebenen Gattung erreicht, das dadurch gekennzeichnet ist, daß es als wesentlichen Bestandteil einen Ester der allgemeinen Formel I

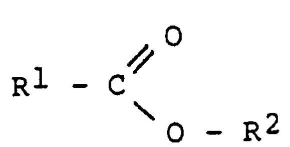

(I)

enthält, worin

$R^1$ und $R^2$ gleich oder verschieden sein können und $(C_1$-$C_{13})$n- oder iso-Alkyl, $C_5$-, $C_6$- oder $C_{12}$-Cycloalkyl, $(C_1$-$C_3)$Alk-$C_6$-aryl, $C_6$ oder $C_{10}$-Aryl bedeuten, mit der Maßgabe, daß die Summe der Kohlenstoffatome in $R^1$ und $R^2$ 6 bis 13 beträgt.

Besonders bevorzugt sind diejenigen Ester der allgemeinen Formel I, deren Summe der Kohlenstoffatome in $R^1$ und $R^2$ 6 bis 10 beträgt.

Insbesondere bevorzugt sind Ester der allgemeinen Formel I, worin

$R^1$ $(C_1$-$C_{13})$n-Alkyl, insbesondere $(C_1$-$C_5)$n-Alkyl, $C_{12}$-Cycloalkyl, Alkaryl insbesondere Benzyl und Phenyl, sowie

$R^2$ $(C_5$-$C_9)$n- oder iso-Alkyl, sofern $R^1$ kein Alkaryl oder Phenyl ist, $(C_1$-$C_4)$n- oder iso-Alkyl, insbesondere $(C_1$-$C_4)$n-Alkyl, sofern $R^1$ Benzyl oder Phenyl ist, Benzyl oder Phenyl, sofern $R^1$ $(C_1$-$C_5)$n-Alkyl oder $(C_1$-$C_5)$iso-Alkyl ist,

bedeuten.

Beispiele für besonders geeignete Ester, die unter die allgemeine Formel I fallen, sind:

Amylacetat, Isoamylacetat, Hexylacetat, Cyclohexylacetat, Ethylhexylacetat, Nonylacetat, Isononylacetat, Propylpropionat, Propylbutyrat, Butylbutyrat, Isobutylbutyrat, Benzylacetat, Benzoesäuremethylester.

Das erfindungsgemäße Entwicklungslösemittel kann Ester der allgemeinen Formel I sowohl einzeln als auch als Gemisch verschiedener Ester, die unter die allgemeine Formel I fallen, enthalten. Bevorzugt sind Entwicklungslösemittel, die lediglich einen Ester der allgemeinen Formel I enthalten.

Das erfindungsgemäße Entwicklungslösemittel enthält 55 bis 100 Gew.-%, insbesondere 55 bis 90 Gew.-%, Ester der allgemeinen Formel I.

Neben den Estern der allgemeinen Formel I kann das erfindungsgemäße Entwicklungslösemittel andere Lösemittel als Zusätze enthalten, insbesondere dann, wenn die Polymerschicht noch eine polyamidhaltige Schutzschicht enthält. In diesem Fall werden als zusätzliche Lösemittel Alkohole, insbesondere höhersiedende Alkohole, bevorzugt.

Die mit dem erfindungsgemäßen Entwicklungslösemittel zu entwickelnden, durch Photopolymerisation vernetzbaren Schichten enthalten als Hauptbestandteile im wesentlichen ein Bindemittel auf der Basis eines elastomeren Polymeren, ein mit dem Bindemittel verträgliches photopolymerisierbares Monomeres und einen Photoinitiator. Die Schichten können auch mehrere verschiedene Bindemittel, Monomere oder Photoinitiatoren enthalten.

Als Zusätze können die Schichten Farbstoffe, Pigmente, Lichthofschutzmittel, Antioxidantien, Weichmacher, Antiozonantien, Vernetzungsmittel, Regler, Füllmittel, Flußmittel und andere Mittel enthalten, die die Schicht in ihrer Wirkungsweise verbessern.

Weitere Hilfsmittel, die der beschriebenen Schicht zugesetzt werden können, sind z. B. Inhibitoren der thermischen Polymerisation wie Hydrochinon und seine Derivate, 2,6-Di-tert.-butyl-p-kresol, Nitrophenole, Nitrosamine, wie N-Nitrosodiphenylamin, oder Salze des N-Nitrosocyclohexylhydroxylamins, z. B. dessen Alkali-oder Aluminiumsalze.

Besonders bevorzugt sind solche durch Photopolymerisation vernetzbare Schichten, die als Bindemittel Polymerisate von konjugierten aliphatischen Dienen, deren Monomerbausteine 4 bis 5 Kohlenstoffatome aufweisen, enthalten. Insbesondere sind hierbei zu nennen Naturkautschuk, Homopolymerisate von Butadien und Isopren, Copolymerisate von Butadien und Isopren, Copolymerisate von Butadien und/oder Isopren mit anderen Monomeren, wie Styrol, Vinyltoluol, Acrylnitril oder (Meth)Acrylsäurealkylester, z. B. Nitrilkautschuke nach der EP-A 064 564, statistische Styrol/Butadien-, -/Isopren-, und -/Isopren/Butadien-Copolymerisate oder Blockpolymerisate aus Styrolmonomeren und Butadien und/oder Isopren mit einem Styrolgehalt von 10 bis 50 Gew.-%. Elastomere dieser Art werden in den DE-B 22 15 090, DE-A 24 56 439, DE-A 29 42 183 und DE-A 21 38 582 beschrieben.

Die durch Photopolymerisation vernetzbaren Schichten enthalten im allgemeinen 20 bis 95, vorzugsweise 30 bis 95 Gew.-% Bindemittel.

Geeignete Monomere mit einer oder mehreren polymerisierbaren olefinischen Doppelbindungen sind insbesondere Ester und Amide von Acryl- und Methacrylsäure. Beispiele sind die verträglichen Mono- und Diacrylate sowie -methacrylate von ein- oder mehrwertigen Alkoholen, wie Ethylenglykol, Di-, Tri-, Tetra- oder Polyethylenglykolen, letztere bevorzugt mit 10 bis 15 Ethylenglykoleinheiten, 1,3-Propandiol, 1,6-Hexandiol, Dodecandiol, Glycerin, 1,1,1-Trimethylolpropan, 1,2,4-Butantriol oder Penta erythrit, z. B. Ethylenglykol-monomethacrylat, 1,3-Propandiol-monomethacrylat, Hexandioldiacrylat, Hexandioldimethacrylat, 2-Ethylhexylacrylat, Laurylmethacrylat, Stearylmethacrylat, Glycerinmono- oder -diacrylat, 1,2,4-Butantriolmonomethacrylat, Pentaerythrittriacrylat, Polyethylenglykolmethyletheracrylat, Tetradecaethylenglykoldimethacrylat oder der Triether aus Glycerin und 3 mol N-Methylolacrylamid oder -methacrylamid. Die Menge an Monomeren in der Schicht liegt im allgemeinen bei 1 bis 70, bevorzugt bei 2 bis 50 Gew.-% der nichtflüchtigen Bestandteile des Gemisches.

Als Photoinitiatoren kommen die bekannten Verbindungen in Frage, die eine hinreichende thermische Stabilität bei der Verarbeitung der Aufzeichnungsmaterialien sowie eine hinreichende Radikalbildung bei Belichtung unter Initiierung der Polymerisation der Monomeren aufweisen. Sie sollen Licht im Wellenlängenbereich von ca. 250 bis 500 nm unter Bildung von Radikalen absorbieren. Beispiele geeigneter Photoinitiatoren sind Acyloine und deren Derivate wie Benzoin, Benzoinalklyether, z. B. Benzoinisopropylether, vicinale Diketone und deren Derivative, z. B. Benzil, Benzilacetale wie Benzildimethylketal, Fluorenone, Thioxanthone, Mehrkernchinone, Acridine und Chinoxaline; ferner Trichlormethyl-s-triazine, 2-Halogenmethyl-4-vinyl-1,3,4-oxadiazolderivate, mit Trichlormethylgruppen substituierte Halogenoxazole, Trihalogenmethylgruppen enthaltende Carbonylmethylenheterocyclen gemäß DE-A 33 33 450, Acylphosphinoxidverbindungen, wie sie z. B. in der DE-A 31 33 419 beschrieben sind, und andere phosphorhaltige Photoinitiatoren, z. B. die in der deutschen Patentanmeldung P 38 27 735.2 beschriebenen 6-Acyl-(6H)-dibenz-[c,e][1,2]-oxaphosphorin-6-oxide, insbesondere das 6-(2,4,6-Trimethylbenzoyl)(6H)dibenz-[c,e][1,2]-oxaphosphorin-6-oxid. Die Photoinitiatoren lassen sich auch in Kombination miteinander oder mit Coinitiatoren bzw. Aktivatoren verwenden, z. B. mit Michlers Keton und seinen Derivaten oder 2-Alkylanthrachinonen. Die Menge an Photoinitiator beträgt im allgemeinen 0,01 bis 10, bevorzugt 0,5 bis 5 Gew.-% der Schicht.

Die durch Photopolymerisation vernetzbaren Gemische lassen sich für die Herstellung von Relief- und Flexodruckplatten durch Gießen aus Lösung oder Extrudieren und Kalandrieren zu Schichten einer Dicke von 0,02 bis 10, vorzugsweise von 0,2 bis 6 mm, ausformen. Die Schicht kann auf die Oberfläche eines geeigneten Trägers laminiert oder es kann eine Lösung des Gemisches auf einen Schichtträger aufgebracht werden.

Außer für die Herstellung von Reliefdruckplatten werden die genannten Schichten z. B. auch zur Herstellung von Flachdruckplatten, Tiefdruckzylindern, Siebdruckschablonen und Photoresists verwendet.

Geeignete Träger sind je nach Verwendungszweck, z. B. Polyesterfolien, Stahl- oder Aluminiumbleche, Kupferzylinder, Siebdruckschablonenträger, Schaumstofflagen, gummielastische Träger oder Leiterplatten. Es kann auch vorteilhaft sein, auf die lichtempfindliche Aufzeich nungsschicht eine Deck- bzw. Schutzschicht, z. B. eine dünne Schicht aus Polyvinylalkohol oder Polyamid, oder eine abziehbare Deckfolie, z. B. aus Polyethylenterephthalat, aufzubringen. Weiterhin kann eine Vorbeschichtung des Trägers vorteilhaft sein. Die zusätzliche Schicht zwischen dem Träger und der lichtempfindlichen Schicht kann z. B. als Lichthofschutzschicht oder als Haftschicht wirksam sein.

Erfindungsgemäß wird ferner ein Verfahren zur Herstellung von durch Photopolymerisation vernetzten Reliefformen beansprucht. Hierbei werden die durch Photopolymerisation vernetzbaren Schichten bildmäßig mit aktinischem Licht aus Lichtquellen wie Quecksilberdampflampen oder Leuchtstoffröhren belichtet, wobei die emittierte Wellenlänge bei 230 bis 450 nm, bevorzugt zwischen 300 und 420 nm liegt. Das Entfernen der unbelichteten und unvernetzten Schichtanteile erfolgt mit dem erfindungsgemäßen Entwicklungslösemittel durch Sprühen, Waschen oder Bürsten. Zweckmäßig werden die entwickelten Reliefformen bei Temperaturen bis 120 °C getrocknet und gegebenenfalls gleichzeitig oder danach mit aktinischem Licht nachbelichtet.

Die erfindungsgemäßen, durch Photopolymerisation vernetzten Reliefformen eignen sich besonders zur Herstellung von Druckformen, vor allem Hoch- und Reliefdruckformen, die besonders für den Flexodruck geeignet sind.

Die Erfindung wird durch die nachstehenden Beispiele erläutert.

## Beispiel 1

Eine handelsübliche Flexodruckplatte auf der Basis eines Styrol-Isopren-Styrol-Dreiblockpolymerisates als Elastomer (®Cyrel HL) mit einer Schichtdicke von 2,8 mm wurde zunächst von der Rückseite her mit einem handelsüblichen Röhrenbelichter vollflächig 76 s belichtet und anschließend durch eine aufgelegte Negativvorlage bildmäßig 12 min lang belichtet. Nach Entfernen der Deckschicht wurde die belichtete Platte in einem handelsüblichen, mit Bürsten versehenen Entwicklungsgerät mit Hexylacetat mit einem Anteil an Butanol von 15 Gew.-% entwickelt. Die Auswaschzeit, die zu den besten Ergebnissen führte, lag bei 5 min.

Die Flexodruckform wurde 1 h bei 50 °C getrocknet und 15 h bei Raumtemperatur gelagert. Nach üblicher Nachbehandlung mit einer wäßrigen Bromlösung ergab sich eine Flexodruckform von ausgezeichneter Qualität.

## Beispiel 2

Eine handelsübliche Platte entsprechend Beispiel 1 wurde 76 s von der Rückseite vollflächig belichtet und anschließend ohne Negativvorlage von der Vorderseite 12 min belichtet. Nach Entfernen der Deckschicht wurde die Platte (50 mm Durchmesser) 10 min in 50 ml Hexylacetat gelegt. Danach wurde die Platte abgewischt, 1 h bei 50 °C getrocknet und 17 h gelagert. Nach der Lagerung konnte lediglich eine Gewichtszunahme der Platte, die vom nicht entwichenen Entwicklungslösemittel herrührte, von 0,42 % bestimmt werden.

Beispiel 3

Es wurde wie in Beispiel 2 vorgegangen. Als Entwicklungslösemittel wurde aber Cyclohexylacetat verwendet. Die Gewichtszunahme der Platte nach Trocknung und Lagerung betrug 1,4 %.

Beispiel 4

Es wurde wie in Beispiel 2 vorgegangen, mit der Ausnahme, daß als Entwicklungslösemittel Butylbutyrat verwendet wurde. Die Gewichtszunahme der Platte nach Trocknung und Lagerung betrug nur 1,05 %.

Beispiel 5 (Vergleichsbeispiel)

Eine handelsübliche Platte gemäß Bespiel 2 wurde entsprechend der Vorschrift in Beispiel 2 verarbeitet, mit der Ausnahme, daß als Entwicklungslösemittel Xylol verwendet wurde. Die Gewichtszunahme der Platte nach Trocknung und Lagerung gemäß den Bedingungen in Beispiel 2, betrug aber 1,92 %. Das Lösemittel ist daher noch zu einem größeren Anteil in der Platte enthalten.

Beispiel 6 (Vergleichsbeispiel)

Entsprechend Beispiel 2 wurde eine handelsübliche Platte behandelt. Als Entwicklungslösemittel wurde jedoch Limonen verwendet. Die Gewichtszunahme der Platte nach Trocknung und Lagerung betrug 1,92 %.

Beispiel 7

Zur Ermittlung des Aufnahmevermögens (Kapazität) von Entwicklungslösemitteln an Bestandteilen aus nicht ver netzten Bereichen eines Styrol-Isopren-Styrol-Dreiblockcopolymeren (®Cyrel HL) wurde die Viskosität der entsprechenden Entwicklungslösemittel bei bestimmten Feststoffgehalten von Bestandteilen aus der Schicht nach deren Entwicklung gemessen. Tabelle 1 zeigt die Viskositätswerte, die in einem Ubbelohde-Viskosimeter bei 25 °C bestimmt wurden, für Feststoffgehalte von 5, 7,5 und 10 Gew.-%. Während die erfindungsgemäßen Entwicklungslösemittel noch bei einem Feststoffgehalt von 7,5 Gew.-% eine Viskosität aufwiesen, die eine sehr rasche Entwicklungsgeschwindigkeit ermöglichte, war die Viskosität von Perchlorethylen schon bei einem Feststoffgehalt von 5 Gew.-% derart hoch, daß eine rasche Entwicklung nicht mehr gewährleistet war.

Tabelle 1

| | Viskosität [cSt] für verschiedene Feststoffgehalte [Gew.-%] | | |
|---|---|---|---|
| Entwicklungslösemittel | 5 | 7,5 | 10 |
| Butylbutyrat | 9,1 | 22 | 40,6 |
| Hexylacetat | 13 | 28 | 68 |
| Perchlorethylen | 37,1 | 120,8 | 333,5 |

## Ansprüche

1. Entwicklungslösemittel für durch Photopolymerisation vernetzbare Schichten, enthaltend ein Bindemittel auf der Basis eines elastomeren Polymeren, ein hiermit verträgliches photopolymerisierbares Monomeres, sowie einen Photoinitiator, dadurch gekennzeichnet, daß das Entwicklungslösemittel als wesentlichen Bestandteil einen Ester der allgemeinen Formel I

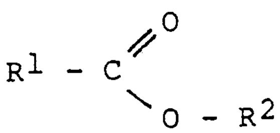

(I)

enthält, worin
$R^1$ und $R^2$ gleich oder verschieden sein können und $(C_1$-$C_{13})$n- oder iso-Alkyl, $C_5$-, $C_6$- oder $C_{12}$-Cycloalkyl, $(C_1$-$C_3)$Alk-$C_6$-aryl, $C_6$ oder $C_{10}$-Aryl bedeuten, mit der Maßgabe, daß die Summe der Kohlenstoffatome in $R^1$ und $R^2$ 6 bis 13 beträgt.

2. Entwicklungslösemittel nach Anspruch 1, dadurch gekennzeichnet, daß 55 bis 100 Gew.-%, insbesondere 55 bis 90 Gew.-%, Ester der allgemeinen Formel I enthalten sind.

3. Entwicklungslösemittel nach Anspruch 1 oder 2, dadurch gekennzeichnet, daß das Lösemittel als Zusatz einen insbesondere höhersiedenden Alkohol enthält.

4. Verfahren zur Herstellung von durch Photopolymerisation vernetzten Reliefformen, bei dem man die durch Photopolymerisation vernetzbaren Schichten bildmäßig mit aktinischem Licht belichtet und die unvernetzten Anteile der Schichten mit einem Entwicklungslösemittel auswäscht, dadurch gekennzeichnet, daß das Entwicklungslösemittel einen Ester gemäß den Ansprüchen 1 bis 3 enthält.

5. Verfahren nach Anspruch 4, dadurch gekennzeichnet, daß man die Reliefform nach dem Auswaschen bei Temperaturen bis 120 °C trocknet und ggf. gleichzeitig oder danach mit aktinischem Licht nachbelichtet.